# EUROPÄISCHE PATENTSCHRIFT

(11) **EP 0 378 719 B1**
(45) Veröffentlichungstag und Bekanntmachung des Hinweises auf die Patenterteilung: **27.04.1994**
(21) Anmeldenummer: 89100802.1
(22) Anmeldetag: 18.01.1989
(51) Int. Cl.: H04L 27/02, H04L 27/34

(54) **Digitaler Verzerrer**
Digital distortion generator
Générateur de distorsions numérique

(43) Veröffentlichungstag der Anmeldung: 25.07.1990
(73) Patentinhaber: SIEMENS AKTIENGESELLSCHAFT, 80333 München (DE)
(72) Erfinder: Nossek, Josef A., Dr.-Ing., D-8127 Iffeldorf (DE); Noll, Tobias, Dipl.-Ing., D-8056 Neufahrn (DE); Ens, Hermann, Dr.-Ing., D-8043 Unterföhring (DE)

(56) Entgegenhaltungen:
- EP-A- 0 112 107
- EP-A- 0 281 652
- GB-A- 2 173 074

## Beschreibung

Die Erfindung bezieht sich auf einen digitalen Verzerrer (Vor- oder Nachverzerrer) für die Sende- / Empfangseinrichtungen eines digitalen Nachrichtenübertragungssystems mit komplexer Amplitudenmodulation, insbesondere Quadraturamplitudenmodulation, mit einer Einrichtung zur Umwandlung der den Signalort angebenden Daten I₀ und Q₀ der beiden Kanäle (I- und Q-Kanal) von kartesischen in polare Koordinaten a₀ und φ₀, mit einem Speicher und einer Einrichtung zur Umwandlung der nach vorheriger Addition erhaltenen vorverzerrten bzw. nachverzerrten Werte für den Betrag und die Phase des verzerrten Signalortes in polaren Koordinaten in die verzerrten Daten für den I- und Q-Kanal in entsprechende kartesische Koordinaten.

Eine solche Anordnung ist im wesentlichen durch die GB-A-2 173 074 bekannt. Dabei bildet der Speicher (RAM) ein Kernelement in Verbindung mit der Einrichtung zur Umwandlung der Daten mit dem Nachteil, daß der RAM sehr groß ist bei komplexer Modulation.

Um immer mehr Information pro Zeit und Frequenzband übertragen zu können, wird in modernen Digital - Richtfunksystemen mit Quadraturamplitudenmodulation die Modulationsstufenzahl immer weiter erhöht. Mit dieser zunehmend verfeinerten Quantisierung der Modulation dürfen nurmehr immer kleinere Signalverfälschungen, beispielsweise bedingt durch die Nichtlinearität des Sendeverstärkers oder auch anderer Systemkomponenten, zugelassen werden. Da in Sendeverstärkern geringste Nichtlinearität in der Regel nur mit großem Aufwand und damit verminderter Wirtschaftlichkeit erreichbar ist, werden im Richtfunksender sogenannte Vorverzerrer (predistorter) eingesetzt. Diese erzeugen eine Nichtlinearität, die invers sein soll zur Nichtlinearität des Sendeverstärkers und der übrigen nichtlinearen Systemkomponenten. Damit wird eine Kompensation der Nichtlinearität erzielt, die Signalübertragung verbessert, die Forderungen an den Sendeverstärker reduziert und damit die Wirtschaftlichkeit des System erhöht. Eine solche Einrichtung mit einem Vorverzerrer zur Linearisierung eines Leistungsverstärkers für ein digitales Datensystem ist beispielsweise aus der US-A-4 291 277 bekannt.

Die Nichtlinearität des Sendeverstärkers wirkt durch zwei Effekte signalverfälschend, nämlich durch die Amplitudenkompression (AM - AM) und durch die Phasenkonversion (AM - PM).

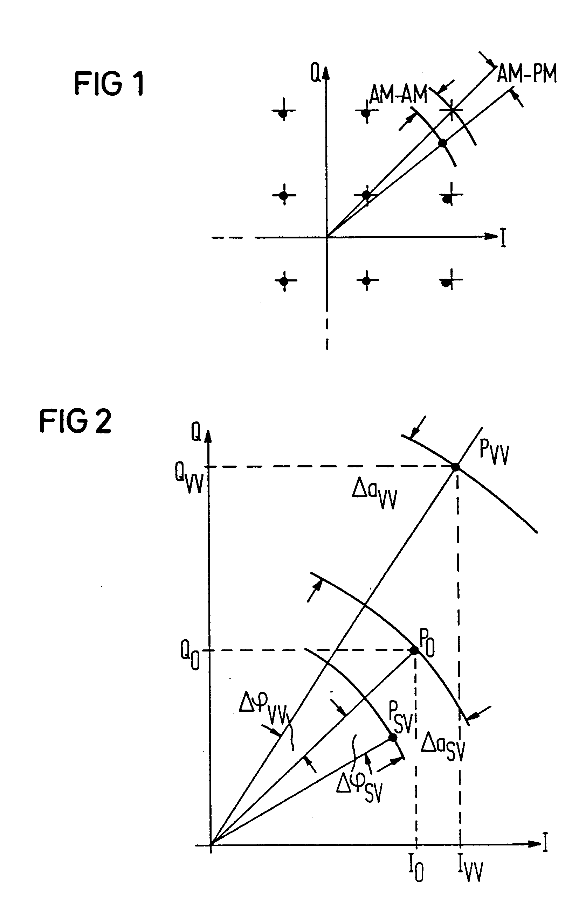

Die Größe beider Effekte hängt von der Ansteuerleistung des Sendeverstärkers ab. Figur 1 zeigt, wie diese beiden Effekte ein mit Quadraturamplitudenmodulation (QAM) beaufschlagtes Signal verfälschen können. Es ist dabei ein Ausschnitt einer 16 QAM -Konstellation gezeigt, wobei die Soll - Lagen der Konstellationspunkte mit einem Kreuz, die Ist - Lagen mit einem Punkt eingezeichnet sind. Die Konstellationspunkte, d. h. die Signalwerte zum Abtastzeitpunkt, werden ausgehend von ihren Soll -Lagen im Abstand zum Ursprung (Amplitude) komprimiert und in ihrer Phase gedreht. Dies trifft die äußersten Signalpunkte am stärksten.

Ein Vorverzerrer, der diese Effekte des Sendeverstärkers kompensieren soll, muß also gegenläufige (inverse) Amplitudenexpansion und eine gegenläufige Phasenkonversion aufweisen. Er hebt die Signalamplituden vor dem Sendeverstärker so weit an, daß zusammen mit dessen Kompression die gewünschte lineare Übertragung zustande kommt. Die Phase dreht er gegenläufig soweit, daß insgesamt eine amplitudenunabhängige Phase resultiert.

Analoge Vorverzerrer, wie sie bisher in der ZF - oder RF - Lage eingesetzt werden, haben nur eine begrenzte Anpassungsfähigkeit der Übertragungskennlinie an die zu kompensierende Kennlinie des Sendeverstärkers und eine begrenzte Flexibilität.

Eine Alternative hierzu sind digitale Vorverzerrer, die bereits im Basisband die noch digital vorliegenden Daten des Signals in den I - und Q - Kanälen entsprechend einer Vorverzerrung verändern. Die Funktion eines digitalen Vorverzerrers soll nachstehend anhand von Figur 2 erläutert werden. Es werden dabei die beiden Datenströme I und Q, die in digitaler Form den Ort des zum jeweiligen Zeitpunkt angesprochenen Signalpunktes in der komplexen Signalebene angeben, im digitalen Vorverzerrer so verändert, daß die Kompression und Drehung des Signalpunktes durch die Nichtlinearität des Sendeverstärkers gerade kompensiert wird. Ohne Vorverstärker würde der Sendeverstärker den Signalpunkt Pₒ aufgrund seiner Amplitudenkompression und Phasenkonversion um den Betrag Δ a_{SV} komprimieren und um die Phase Δφ_{SV} drehen, so daß man zum Punkt P_{SV} gelangt. Der Vorverzerrer soll nun die Signaldaten so verändern, daß aus dem Punkt Pₒ der Punkt P_{VV} wird. Dieser weist einen um Δa_{VV} höheren Berag und eine um Δφ_{VV} verdrehte Phase auf. Δ a_{VV} und Δφ_{VV} sind dabei so gewählt, daß der mit dem vorverzerrten Punkt P_{VV} angesteuerte Sendeverstärker aufgrund seiner Nichtlinearität genau den gewünschten Punkt Pₒ erzeugt. Die dazu notwendigen Werte Δ a_{VV} und Δφ_{VV} können aus den AM - AM und AM - PM Charaktaristiken des jeweiligen Sendeverstärkers gewonnen werden.

Zwischen dem digitalen Vorverzerrer und der zu entzerrenden Nichtlinearität, also des Sendeverstärkers oder auch anderer Komponenten, soll keine nennenswerte Formung des Sendespektrums, also keine Filterung erfolgen. Eine entsprechende Frequenzabhängigkeit würde nämlich eine effektvolle Kompensation der Nichtlinearitäten wesentlich erschweren, wenn nicht gar verhindern.

Der Erfindung liegt die Aufgabe zugrunde, einen digitalen Verzerrer als Vor- oder Nachverzerrer in Sende- /Empfangseinrichtungen zu schaffen, der insbesondere als Vorverzerrer bei Verwendung eines vor ihm angeordneten digitalen Impulsformungsfilters eine effektvolle Kompensation der Nichtlinearität des Sendeverstärker und anderer Komponenten erlaubt und gleichzeitig mit geringem Aufwand realisierbar ist.

Diese Aufgabe wird mit einem digitalen Verzerrer (Vor- oder Nachverzerrer) der eingangs beschriebenen Art gemäß der Erfindung in der Weise gelöst, daß der Speicher eingangsseitig mit dem Ausgang der Einrichtung zur Umwandlung der den Signalort angebenden Daten I₀ und Q₀ von kartesischen in polare Koordinaten verbunden ist, an dem der Anteil des Betrages a₀ der Daten in polaren Koordinaten (a₀ und φ₀) anliegt und der die zu jedem adressierten Betrag gehörenden Verzerrungswerte (Differenz von Soll-Signalort zu verzerrtem Signalort) nach Betrag und Phase enthält, die als Korrekturwerte (Verzerrwerte) zu den aus den I₀- und Q₀-Daten abgeleiteten Daten a₀ und φ₀ des Signalortes in polaren Koordinaten in Addierern addiert werden.

Vorteilhafte Ausgestaltungen und Weiterbildungen des Erfindungsgegenstandes sind in den Unteransprüchen angegeben.

Nachstehend wird die Erfindung anhand von in der Zeichnung dargestellten Ausführungsbeispielen näher erläutert.

Es zeigen:
- Fig. 3 und 5: zwei verschiedene sendeseitige Systemkonfigurationen im Blockschaltbild mit einem Vorverzerrer entsprechend der Darstellung in Fig.4 bzw. 6,
- Fig.7 bis 11: verschiedene Ausführungsformen eines Vorverzer rers,
- Fig. 12: eine empfangsseitige Systemkonfiguration mit einem digitalen Nachverzerrer,
- Fig. 13 Fig. 14 u.15: den zugehörigen digitalen Nachverzerrer und die Beschaltung des CORDIC - Operators als Beispiel für die Transformationen von kartesischen in polare Koordinaten und von polaren in kartesische Koordinaten.

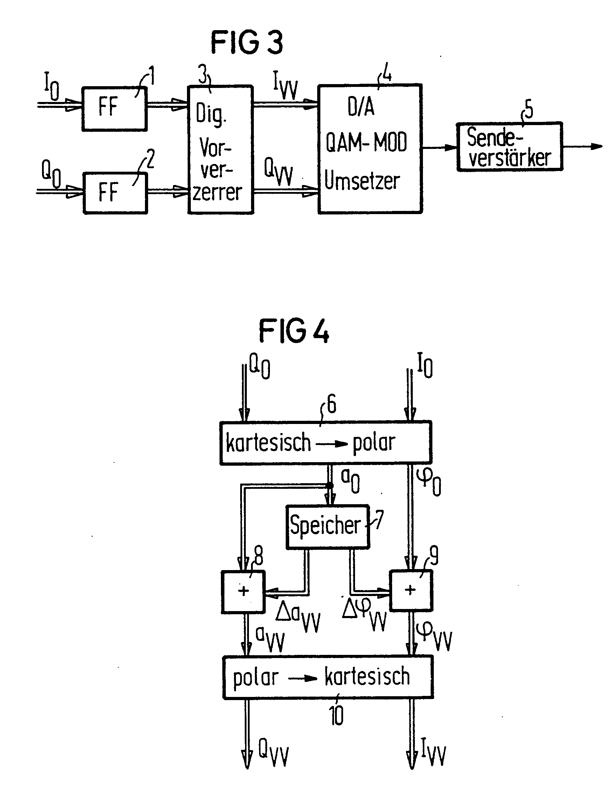

Figur 3 zeigt eine sendeseitige Systemkonfiguration mit einem digitalen Vorverzerrer im Blockschaltbild. Dabei werden die Daten Iₒ und Qₒ (oder ein Teil der Daten) des I - und Q - Kanals, die den Signalort in kartesischen Koordinaten angeben, und zwar in Betrag und Phase, über jeweils ein mit FF bezeichnetes Formfilter 1 bzw. 2 an die Eingänge eines digitalen Vorverzerrers 3 geführt. Den Ausgängen des digitalen Vorverzerrers 3, der in Figur 4 dargestellt und nachstehend näher erläutert wird, sind die Daten I_{VV} und Q_{VV} entnehmbar, die einer Einrichtung 4 zugeführt werden. Diese Einrichtung 4 enthält einen D/A-Wandler, einen QAM-Modulator und einen Umsetzer. Das Ausgangssignal dieser Einrichtung 4 wird einem Sendeverstärker 5 zugeführt.

Figur 4 zeigt den bereits genannten digitalen Vorverzerrer 3. Dieser besteht aus einer Einrichtung 6 zur Umwandlung der Daten Iₒ und Qₒ von kartesischen in polare Koordinaten aₒ und φₒ. Diese Einrichtung wird ebenso wie eine entsprechende Einrichtung zur Umwandlung von polaren in kartesische Koordinaten an späterer Stelle näher erläutert. Von den Daten aₒ und φₒ, die den Signalort in polaren Koordinaten angeben, wird lediglich der den Betrag angebende Anteil aₒ einem Speicher 7 zugeführt, der die zu jedem adressierten Betrag gehörenden Verzerrungswerte, d. h. die Differenz von Soll-Signalort zu verzerrtem Signalort nach Betrag und Phase enthält. Diese Verzerrungswerte Δa_{VV} und Δφ_{VV} werden in jeweils einem Addierer 8,9 zu den aus den Iₒ - und Qₒ - Daten abgeleiteten Daten aₒ und φₒ des Signalortes in polaren Koordinaten addiert. Man erhält so die vorverzerrten Werte für den Betrag a_{VV} und die Phase φ_{VV} in polaren Koordinaten, die in einer nachfolgenden Einrichtung 10 zur Umwandlung von polaren in kartesische Koordinaten in entsprechende vorverzerrte Daten I_{VV} und Q_{VV} für den I - und Q - Kanal Koordinaten umgewandelt werden.

Durch die Verwendung lediglich des Betrages aₒ für die Addressierung des Speichers wird bei gleicher Auflösung des Signalortes wie in kartesischen Koordinaten die Anzahl der Addressbits wesentlich verringert, was zu einer Verkleinerung der Speicher führt.

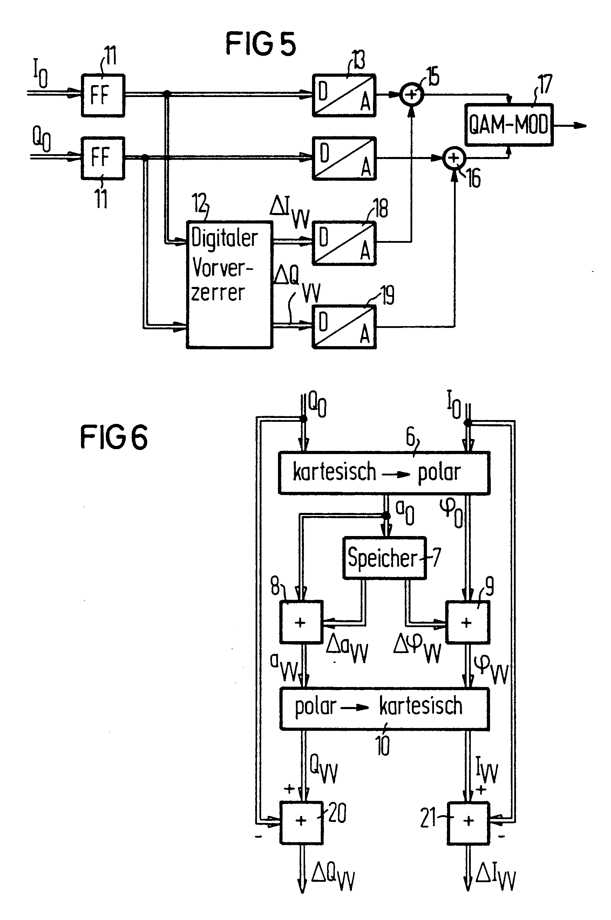

Figur 5 zeigt eine sendeseitige Systemkonfiguration mit einem digitalen Vorverzerrer 12, der in einem Parallelzweig zum Übertragungsweg eingeschaltet ist. Die Daten Iₒ und Qₒ werden wiederum über jeweils ein Formfilter 11 bzw 11′ geführt und gelangen über jeweils einen D/A-Wandler 13 bzw 14 zu einem Addierer 15 bzw. 16, deren Ausgang mit jeweils einem Eingang eines QAM-Modulators 17 verbunden ist. Im Ausgangsweg der Formfilter 11 und 12 ist jeweils eine Leitungsverzweigung vorgesehen, von denen die Daten Iₒ und Qₒ zugleich den Eingängen des digitalen Vorverzerrers 13 zugeführt werden, dessen Ausgänge, die Differenzwerte ΔI_{VV} und ΔQ_{VV} von Soll-Signalort zu verzerrtem Signalort als Korrekturwerte in kartesischen Koordinaten liefern. Diese Werte werden über jeweils einen D/A-Wandler 18 bzw. 19 an die Addierer 15,16 geführt. In Abwandlung von dieser Ausführungsform kann man die Addierer 15,16 im Übertragungsweg vor den D/A - Wandlern 13,14 anordnen. Dann können die D/A - Wandler 18,19 im Parallelzweig entfallen.

Figur 6 zeigt den Aufbau des digitalen Vorverzerrers 13 aus der Schaltung nach Figur 5. Der digitale Vorverzerrer 13 entspricht in seinem Aufbau dem in Figur 4 im Detail dargestellen Vorverzerrer 3. Die einzelnen Baugruppen, nämlich die Einrichtung zur Umwandlung von kartesischen in polare Koordinaten, der Speicher, die beiden Addierer sowie die Einrichtung zur Umwandlung von polaren in kartesische Koordinaten sind daher mit gleichen Bezugszeichen versehen. Dasselbe trifft für die an den einzelnen Punkten der Schaltung eingetragenen Daten in kartesischen und polaren Koordinaten zu. Zusätzlich sind beim digitalen Vorverzerrer zwei Addierer 20 und 21 vorgesehen, in denen die den Signalort in kartesischen Koordinaten angebenden Daten Iₒ und Qₒ mit entgegengesetztem Vorzeichen zu den jeweiligen, die Verzerrung beinhaltenden Daten I_{VV} bzw. Q_{VV} am Ausgang zur Einrichtung zur Umwandlung von polaren in kartesische Koordinaten addiert werden. Dabei werden die Korrekturwerte ΔI_{VV} und ΔQ_{VV} für die Daten im I - Q - Kanal gebildet.

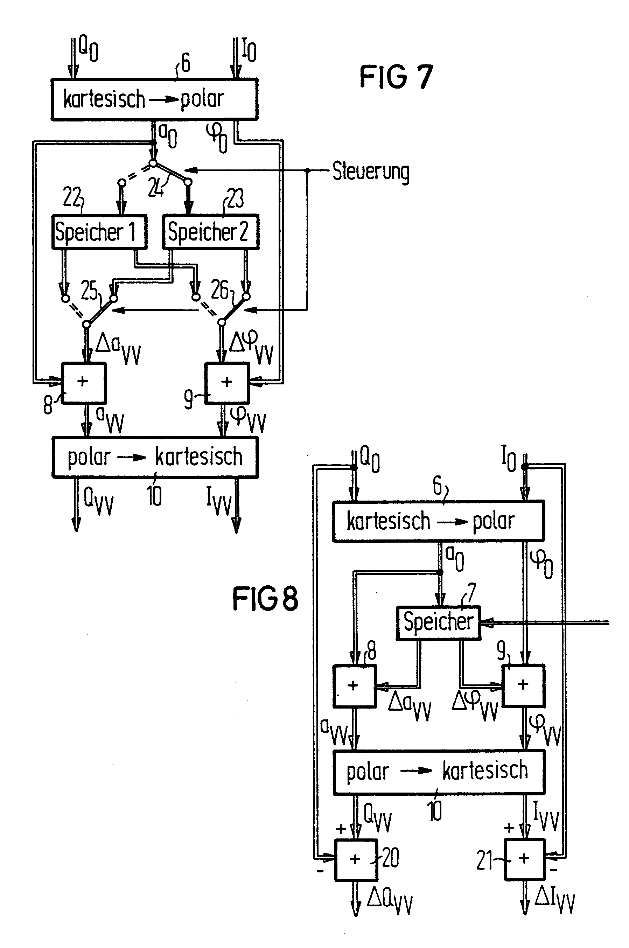

Figur 7 zeigt eine weitere Ausführungsform eines digitalen Vorverzerrers, bei dem im Unterschied zum Vorverzerrer nach Figur 4 der Speicher aus mehreren Speicherelementen 22,23 (mögliche Speicherzahl 1...n), die durch einen eingangsseitigen Umschalter 24 und zwei ausgangsseitige Umschalter 25,26 mittels einer entsprechenden Steuerung wechselweise anschaltbar sind. Dies ermöglicht es, in den einzelnen Speichern verschiedene Kennlinien von Nichtlinearitäten bewirkenden Bauelementen zu speichern sowie eine Anpassung an verschiedene Sendeleistungen des Verstärkers vorzunehmen. Die Steuerung erfolgt dabei in der Weise, daß bei der gewünschten Kennlinie bzw. Sendeleistung ein Steuersignal an die Umschalter gegeben wird zur Anschaltung des entsprechenden Schalterelementes. Dieser Aufbau ist selbstverständlich auch bei einem digitalen Vorverzerrer gemäß Figur 6 in gleicher Weise realisierbar.

Figur 8 zeigt einen digitalen Vorverzerrer, der gemäß dem nach Figur 6 ausgebildet ist. Hierbei ist eine Ansteuerung für den Speicher 7 in der Weise vorgesehen, daß der Speicherinhalt austauschbar ist, wodurch eine Selbstanpassung bei adaptiven Systemen möglich wird. Dies ist in der Figur durch einen zum Speicher geführten Pfeil (Speicherverwaltung) wiedergegeben. Diese Ausbildung ist in gleicher Weise auch bei einem Vorverzerrer nach Figur 4 möglich.

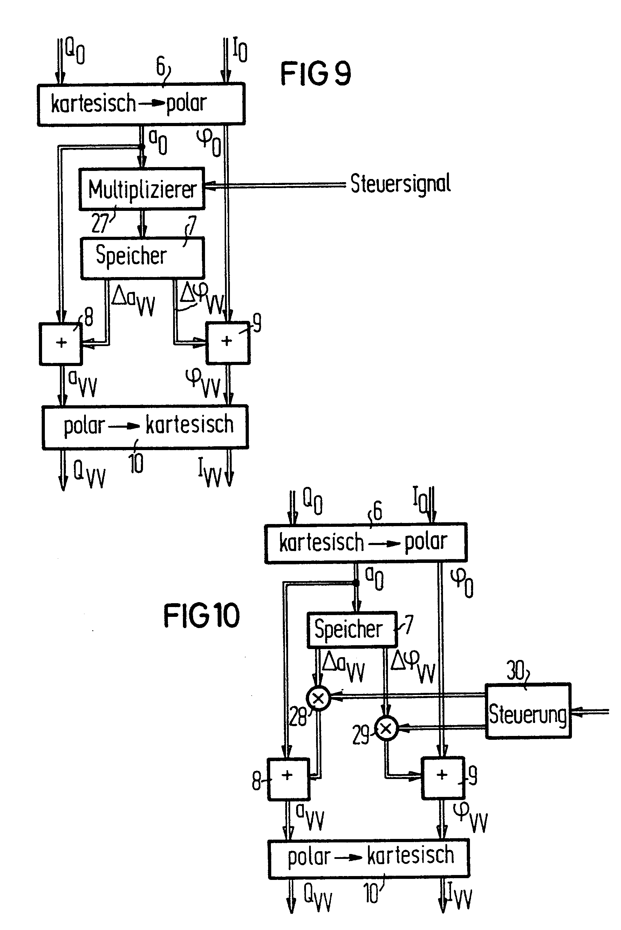

Eine weitere Ausführungsform eines digitalen Vorverzerrers zeigt Figur 9. Bei diesem ist, in Ergänzung zur Ausführungsform nach Figur 4, zwischen der Einrichtung 6 zur Umwandlung von kartesischen in polare Koordinaten und dem Speicher 7 ein von einem Steuersignal angesteuerter Multiplizierer 27 eingeschaltet. Mit diesem ist, ähnlich wie mit den umschaltbaren Speicherelementen, eine Anpassung an verschiedene Kennlinien und Sendeleistungen des Verstärkers möglich.

Figur 10 zeigt, in Abwandlung zum Vorverzerrer nach Figur 9, eine Ausführungsform, bei der im Ausgangskreis des Speichers 7 Multiplizierer angeordnet sind, und zwar ein Multiplizierer 28 im Signalweg des Korrekturwertes Δa_{VV} des Betrages und ein Multiplizierer 29 im Weg für den Korrekturwert Δφ_{VV} der Phase. Beide Multiplizierer 28 und 29 werden von einer gemeinsamen Steuerung 30 angesteuert. Auch hierbei läßt sich durch die Multiplizierer eine Anpassung an unterschiedliche Kennlinien und verschiedene Sendeleistungen des Verstärkers vornehmen.

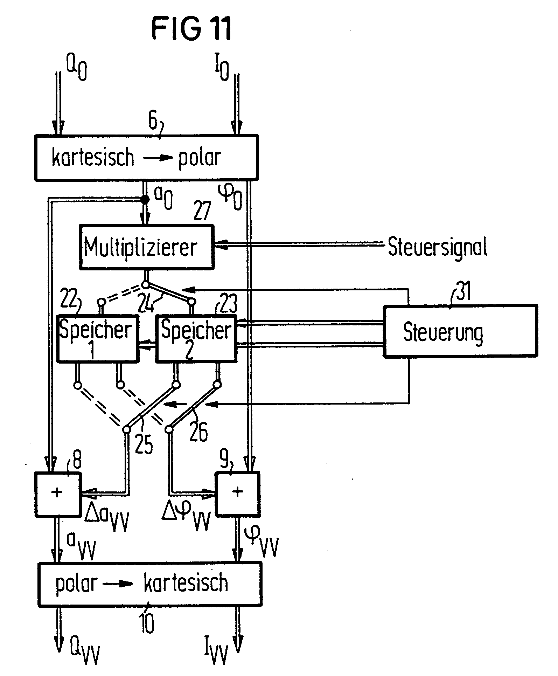

Eine weitere Ausführungsform eines digitalen Vorverzerrers zeigt Figur 11, bei dem ähnlich dem Vorverzerrer nach Figur 9 zwischen der Einrichtung zur Umwandlung von kartesischen in polare Koordinaten und dem Speicher ein Multiplizierer 27 eingefügt ist und ferner der Speicher entsprechend dem Vorverzerrer nach Figur 7 aus mehreren Speicherelementen 22,23 besteht. Letztere sind durch ein- und ausgangsseitige Umschalter 24 bzw. 25,26 umschaltbar. Hierfür ist eine Steuereinrichtung 31 vorgesehen, die ihre Steuersignale entsprechend der Kennlinie bzw. der gewählten Sendeleistung innerhalb der Sendeeinrichtungen abgibt.

Figur 12 zeigt eine empfangsseitige Systemkonfiguration mit einem digitalen Nachverzerrer. Dabei werden die von einer Antenne 32 aufgenommenen analogen Signale über einen Empfänger 33 einem Demodulator 34 zugeführt, dessen Ausgangssignale in digitaler Form vorliegen. Die dabei abgegebenen Daten Iₒ und Qₒ der beiden Kanäle werden einem digitalen Nachverzerrer 35 zugeführt, der in entsprechender Weise wie ein digitaler Vorverzerrer wirkt. Er liefert die verzerrten Daten I_{NV} und Q_{NV} für den I - und Q - Kanal in kartesischen Koordinaten.

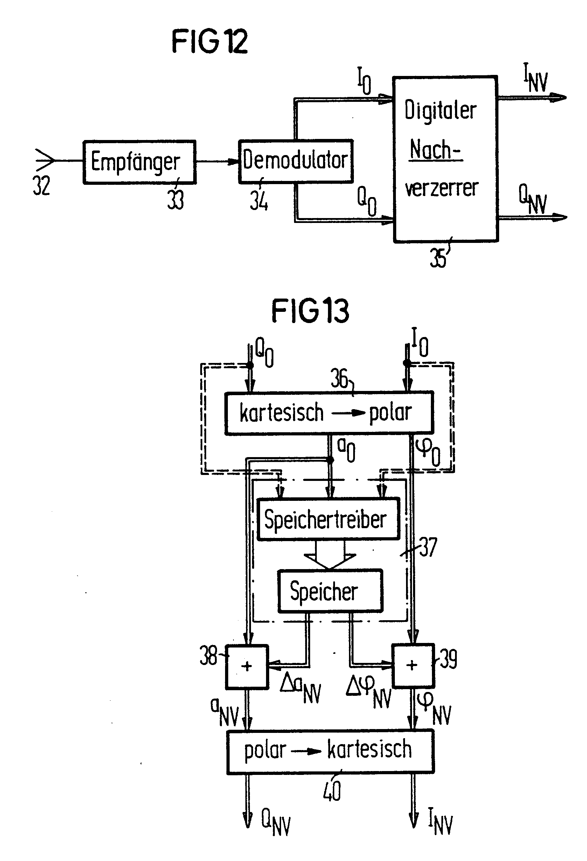

Ein digitaler Nachverzerrer der vorstehend genannten Art zur Kompensation der Nichtlinearitäten ist in Figur 13 dargestellt. Er ist analog zu den vorstehend beschriebenen digitalen Vorverzerrern aufgebaut, d. h. mit einer eingangsseitigen Einrichtung 36 zur Umwandlung der kartesischen in polare Koordinaten, einer Speichereinrichtung 37, Addierern 38,39 sowie einer ausgangsseitigen Einrichtung 40 zur Umwandlung der polaren in kartesische Koordinaten. Die Speichereinrichtung 37 besteht dabei aus einem Speicher und einem vorgeschalteten Speichertreiber, dem von den in polaren Koordinaten vorliegenden Daten der Anteil des Betrages aₒ zugeführt wird. Alternativ sind Verbindungen von den Eingängen der Einrichtung 36 zur Umwandlung von kartesischen in polare Koordinaten, an denen die den Signalort angebenden Daten Iₒ und Qₒ anliegen, zum Speichertreiber vorgesehen. Dies ist durch die strichliert gezeichneten Leitungsverbindungen dargestellt.

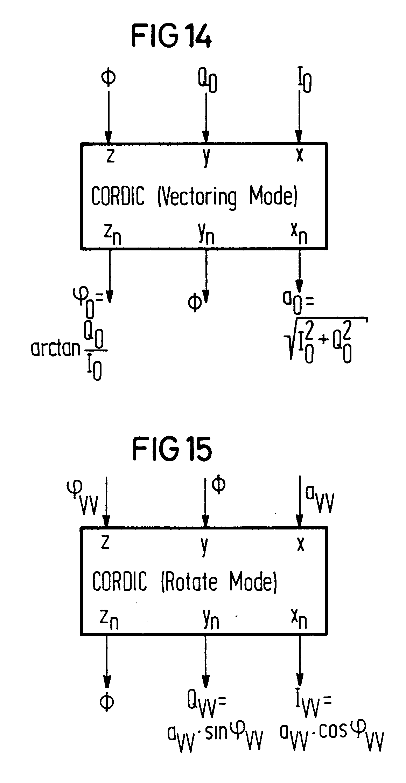

Die Transformationen von kartesischen Koordinaten in polare Koordinaten und umgekehrt können beispielsweise mittels des CORDIC-Operators durchgeführt werden. Nähere Ausführungen hierzu finden sich in dem Aufsatz "A unified algorithm for elementary functions" von J. S. Walter erschienen in Proc. Spring Joint Computer Conference, 1971, pp.379-385. In Figur 14 ist die Beschaltung des CORDIC-Operators für die Transformation von kartesischen in polare Koordinaten (vectoring mode) und in Figur 15 für die Transformation von polaren in kartesische Koordinaten (rotate mode) angegeben. Es werden dabei im ersten Fall aus den Eingangsdaten Iₒ, Qₒ und Φ die Ausgangsdaten aₒ, Φ und φₒ, im zweiten Fall aus den Eingangsdaten a_{VV}, Φ und φ_{VV} die Ausgangsdaten I_{VV}, Q_{VV} und Φ gewonnen.

### Bezugszeichenliste

- 1, 2: - Formfilter
- 3: - dig. Vorverzerrer
- 4: - Einrichtung mit D/A-Wandler, QAM-Modulator und Umsetzer
- 5: - Sendeverstärker
- 6, 36: - Einrichtung zur Umwandlung der Daten von kartesischen in polare Koordinaten
- 7: - Speicher
- 8, 9: - Addierer
- 10, 40: - Einrichtung zur Umwandlung der Daten von polaren in kartesische Koordinaten
- 11, 11′: - Formfilter
- 12: - dig. Vorverzerrer
- 13, 14: - D/A-Wandler
- 15, 16: - Addierer
- 17: - QAM-Modulator
- 18, 19: - D/A-Wandler
- 20, 21: - Addierer
- 22, 23: - Speicherelemente
- 24, 25, 26: - Umschalter
- 27, 28, 29: - Multiplizierer
- 30, 31: - Steuereinrichtungen
- 32: - Antenne
- 33: - Empfänger
- 34: - Demodulator
- 35: - dig. Nachverzerrer
- 37: - Speichereinrichtung
- 38, 39: - Addierer

## Patentansprüche

1. Digitaler Verzerrer (Vor- oder Nachverzerrer) für die Sende-/Empfangseinrichtungen eines digitalen Nachrichtenübertragungssystems mit komplexer Amplitudenmodulation, insbesondere Quadraturamplitudenmodulation, mit einer Einrichtung (6) zur Umwandlung der den Signalort angebenden Daten Iₒ und Qₒ der beiden Kanäle (I - und Q -Kanal) von kartesischen in polare Koordinaten aₒ und φₒ, mit einem Speicher (7) und einer Einrichtung (10) zur Umwandlung der nach vorheriger Addition erhaltenen vorverzerrten bzw. nachverzerrten Werte für den Betrag und die Phase des verzerrten Signalortes in polaren Koordinaten in die verzerrten Daten für den I- und Q-Kanal in entsprechende kartesische Koordinaten, dadurch **gekennzeichnet,** daß der Speicher (7) eingangsseitig mit dem Ausgang der Einrichtung zur Umwandlung der den Signalort angebenden Daten Iₒ und Qₒ von kartesischen in polare Koordinaten verbunden ist, an dem der Anteil des Betrages aₒ der Daten in polaren Koordinaten (aₒ und φₒ) anliegt und der die zu jedem adressierten Betrag gehörenden Verzerrungswerte (Differenz von Soll-Signalort zu verzerrtem Signalort) nach Betrag und Phase enthält, die als Korrekturwerte (Verzerrwerte) zu den aus den Iₒ- und Qₒ- Daten abgeleiteten Daten aₒ und φₒ des Signalortes in polaren Koordinaten in Addierern (8, 9) addiert werden.

2. Verzerrer nach Anspruch 1, dadurch **gekennzeichnet,** daß die den Signalort in kartesischen Koordinaten angebenden Iₒ- und Qₒ- Daten zugleich direkt in einem Summationspunkt (20, 21) zu den jeweiligen, die Verzerrung beinhaltenden Daten für den I- und den Q-Kanal am Ausgang der Einrichtung (7) zur Umwandlung von polaren in kartesische Koordinaten mit entgegengesetzten Vorzeichen addiert werden unter Bildung des Korrekturwertes für die Daten im I- und Q-Kanal.

3. Verzerrer nach Anspruch 1 oder 2, dadurch **gekennzeichnet**, daß die Umwandlung der Daten von kartesischen in polare Koordinaten und in umgekehrter Richtung mittels des CORDIC-Operators erfolgt.

4. Verzerrer nach einem der Ansprüche 1 bis 3, dadurch **gekennzeichnet**, daß der Speicher (7) aus mehreren Speicherelementen (22, 23) besteht, die durch gesteuerte ein- und ausgangsseitige Umschalter (24, 25, 26) wechselweise einschaltbar sind.

5. Verzerrer nach einem der Ansprüche 1 bis 4, dadurch **gekennzeichnet**, daß der Speicherinhalt austauschbar ist.

6. Verzerrer nach einem der Ansprüche 1 bis 5, dadurch **gekennzeichnet**, daß zwischen der Einrichtung (6) zur Umwandlung von kartesischen in polare Koordinaten und dem Speicher (7) ein von einem Steuersignal angesteuerter Multiplizierer (27) eingeschaltet ist.

7. Verzerrer nach einem der Ansprüche 1 bis 5, dadurch **gekennzeichnet**, daß in die die Korrekturwerte von Betrag und Phase abgebenden Ausgangskreise des Speichers (7) jeweils ein von einer gemeinsamen Steuereinrichtung (30) angesteuerter Multiplizierer (28 bzw. 29) eingeschaltet ist.

8. Verzerrer nach einem der Ansprüche 1 bis 7, **gekennzeichnet durch** seine Verwendung als Vorverzerrer auf der Sendeseite eines Übertragungssystems und seine Anordnung zwischen einem Impulsformungsfilter und dem mit einem QAM - Modulator in Reihe liegenden Sendeverstärker.

9. Verzerrer nach einem der Ansprüche 1 bis 7, **gekennzeichnet durch** seine Verwendung als Nachverzerrer auf der Empfangsseite eines Übertragungssystems und seine Anordnung nach dem Demodulator im digitalen Teil des Signalweges.

## Claims

1. Digital distorter (pre- or postdistorter) for the transmitting/receiving devices of a digital telecommunication system having complex amplitude modulation, in particular quadrature amplitude modulation, having a device (6) for converting the data I₀ and Q₀, specifying the signal location, of the two channels (I - and Q-channel) from cartesian into polar coordinates a₀ and φ₀, having a memory (7) and a device (10) for converting the predistorted or postdistorted values, obtained after prior addition, for the absolute value and the phase of the distorted signal location, in polar coordinates into the distorted data for the I- and Q-channel in corresponding cartesian coordinates, characterized in that the memory (7) is connected on the input side to the output of the device for converting the data I₀ and Q₀, specifying the signal location from cartesian into polar coordinates, at which the component of the absolute value a₀ of the data is present in polar coordinates (a₀ and φ₀) and which contains, in terms of absolute value and phase, the distortion values (difference from desired signal location to distorted signal location) belonging to each addressed absolute value, which are added in adders (8, 9) as correction values (distort values) to the data a₀ and φ₀, derived from the I₀ data and Q₀ data, of the signal location in polar coordinates.

2. Distorter according to Claim 1, characterized in that the I₀ data and Q₀ data, specifying the signal location in cartesian coordinates, simultaneously, directly, with opposite signs and accompanied by the formation of the correction value for the data in the I- and Q-channel are added to the respective data, containing the distortion, for the I- and the Q-channel at the output a device (7) for converting from polar into cartesian coordinates.

3. Distorter according to Claim 1 or 2, characterized in that the conversion of the data from cartesian into polar coordinates and in the reverse direction is performed by means of the CORDIC operator.

4. Distorter according to one of Claims 1 to 3, characterized in that the memory (7) comprises a plurality of memory elements (22, 23) which can be switched on alternately by controlled changeover switches (24, 25, 26) on the input and output sides.

5. Distorter according to one of Claims 1 to 4, characterized in that the memory contents are exchangeable.

6. Distorter according to one of Claims 1 to 5, characterized in that a multiplier (27) driven by a control signal is inserted between the device (6) for converting from cartesian into polar coordinates and the memory (7).

7. Distorter according to one of Claims 1 to 5, characterized in that a multiplier (28 or 29) driven by a common control device (30) is inserted in each case into the output circuits of the memory (7) which output the correction values of absolute value and phase.

8. Distorter according to one of Claims 1 to 7, characterized by its use as a predistorter on the transmitting side of a transmission system, and its arrangement between a pulse-shaping filter and the transmitting amplifier, which is connected in series with a QAM modulator.

9. Distorter according to one of Claims 1 to 7, characterized by its use as a postdistorter on the receiving side of a transmission system and its arrangement downstream of the demodulator in the digital part of the signal path.

## Revendications

1. Générateur de distorsion numérique (générateur de pré ou de postaccentuation) pour les dispositifs d'émission/ réception d'un système numérique de transmission d'informations avec modulation complexe en amplitude, notamment modulation d'amplitude en quadrature, comportant un dispositif (6) pour la conversion des données Iₒ et Qₒ, fournissant l'emplacement du signal, des deux canaux (canal I et canal Q) de coordonnées cartésiennes en coordonnées polaires aₒ et φₒ, comportant une mémoire (7) et un dispositif (10) de conversion des valeurs de pré ou de postaccentuation obtenues après une addition préalable pour le module et la phase de l'emplacement du signal distordu en coordonnées polaires, en les données d'accentuation pour les canaux I et Q en coordonnées cartésiennes correspondantes, caractérisé en ce que la mémoire (7) est reliée, côté entrée, à la sortie du dispositif de conversion des données Iₒ et Qₒ, fournissant le l'emplacement du signal, de coordonnées cartésiennes en coordonnées polaires, mémoire à laquelle est appliquée la composante du module aₒ des données en coordonnées polaires (aₒ et φₒ) et qui comporte les valeurs de distorsion (différence entre l'emplacement du signal de consigne et l'emplacement du signal de distortion) correspondant à chaque module adressé, en fonction du module et de la phase, qui sont additionnées, dans des additionneurs (8, 9), en tant que valeurs de correction (valeurs de distorsion), aux données aₒ et φₒ, dérivées à partir des données Iₒ et Qₒ, du lieu de signal en coordonnées polaires.

2. Générateur de distorsion suivant la revendication 1, caractérisé en ce que les données Iₒ et Qₒ fournissant l'emplacement du signal en coordonnées cartésiennes sont simultanément et directement additionnées, en un point de sommation (20, 21), aux données respectives contenant la distorsion pour les canaux I et Q, à la sortie du dispositif (7) de conversion des coordonnées polaires en coordonnées cartésiennes, avec des signes opposés, moyennant la formation de la valeur de correction pour les données dans le canal I et le canal Q.

3. Générateur de distorsion suivant la revendication 1 ou 2, caractérisé en ce que la conversion des données de coordonnées cartésiennes en coordonnées polaires et dans le sens inverse, s'effectue au moyen de l'opérateur CORDIC.

4. Générateur de distorsion suivant l'une des revendications 1 à 3, caractérisé en ce que la mémoire (7) est constituée de plusieurs éléments de mémoire (22, 23) qui sont susceptibles d'être branchés de manière alternée par des commutateurs (24, 25, 26) commandés côté entrée et côté sortie.

5. Générateur de distorsion suivant l'une des revendications 1 à 4, caractérisé en ce que le contenu de la mémoire est susceptible d'être échangé.

6. Générateur de distorsion suivant l'une des revendications 1 à 5, caractérisé en ce qu'entre le dispositif (6) de conversion des coordonnées cartésiennes en coordonnées polaires et la mémoire (7), est branché un multiplicateur (27) commandé par un signal de commande.

7. Générateur de distorsion suivant l'une des revendications 1 à 5, caractérisé en ce que dans le circuit sortie de la mémoire (7) fournissant le module et la phase des valeurs de correction, est branché un multiplicateur (28 ou 29) commandé par un dispositif de commande commun (30).

8. Générateur de distorsion suivant l'une des revendications 1 à 7, caractérisé par son utilisation en tant que dispositif de préaccentuation sur la partie émission d'un système de transmission et par son montage entre un filtre de formation d'impulsions et l'amplificateur d'émission monté en série avec un modulateur QAM.

9. Générateur de distorsion suivant l'une des revendications 1 à 7, caractérisé par son utilisation en tant que dispositif de postaccentuation sur la partie réception d'un système de transmission et par son montage en aval du démodulateur, dans la partie numérique de la voie de transmission de signaux.
